# EUROPÄISCHE PATENTSCHRIFT

(11) **EP 2 097 761 B1**
(45) Veröffentlichungstag und Bekanntmachung des Hinweises auf die Patenterteilung: **24.02.2010**
(21) Anmeldenummer: 07818978.4
(22) Anmeldetag: 13.10.2007
(51) Int. Cl.: G01R 31/26, G01R 31/265, G01N 22/00

(54) **VORRICHTUNG UND VERFAHREN ZUR ERFASSUNG ELEKTRISCHER EIGENSCHAFTEN EINER PROBE AUS EINEM ANREGBAREN MATERIAL**
DEVICE AND METHOD FOR DETECTING ELECTRICAL PROPERTIES OF A SAMPLE COMPOSED OF AN EXCITABLE MATERIAL
DISPOSITIF ET PROCÉDÉ DE DÉTERMINATION DE PROPRIÉTÉS ÉLECTRIQUES D'UN ÉCHANTILLON EN MATÉRIAU EXCITABLE

(30) Priorität: 03.11.2006 DE 102006051577
(43) Veröffentlichungstag der Anmeldung: 09.09.2009
(73) Patentinhaber: Deutsche Solar AG, 09599 Freiberg (DE)
(72) Erfinder: NIKLAS, Jürgen, 09600 Oberschöna (DE); DORNICH, Kay, 09603 Grossschirma OT Reichenbach (DE); ERFURT, Gunter, 09599 Freiburg (DE)
(74) Vertreter: Rau, Albrecht
(86) Internationale Anmeldenummer: PCT/EP2007/008907
(87) Internationale Veröffentlichungsnummer: WO 2008/052648

(56) Entgegenhaltungen:
- WO-A-92/11528
- US-A- 4 286 215
- US-A- 5 138 255
- US-A- 5 438 276

## Beschreibung

Die Erfindung betrifft eine Vorrichtung zur Erfassung elektrischer Eigenschaften einer Probe aus einem anregbaren Material. Außerdem betrifft die Erfindung ein Verfahren zur Erfassung elektrischer Eigenschaften einer Probe aus einem anregbaren Material.

Die Fotoleitfähigkeit von Halbleitern ist seit etwa einem halben Jahrhundert bekannt. Bei diesem Effekt werden in einem Halbleiter durch Einstrahlung von Licht freie Ladungsträger erzeugt. Die genauen Details dieses Prozesses sind materialabhängig. Außerdem können schon kleinste Unregelmäßigkeiten in der Kristallstruktur eines Halbleiters zu gravierenden Unterschieden in der Anzahl und den elektrischen Eigenschaften, wie beispielsweise Beweglichkeit und Lebensdauer, der erzeugten Ladungsträger führen. Derartige Inhomogenitäten wirken sich negativ auf die Qualität von Halbleiter-Bauelementen, beispielsweise Wafern, aus. Es ist daher von größtem Interesse, eine detaillierte Topographie der elektrischen Eigenschaften eines Wafers zu erstellen, um Kristalldefekte, insbesondere schon während der Fertigung des Wafers zu erkennen. Hierzu kann die Wechselwirkung der optisch erzeugten Ladungsträger mit einem externen Mikrowellenfeld eingesetzt werden.

In der DE 44 00 097 A1 ist ein Verfahren beschrieben, bei welchem Licht auf die Oberfläche eines zu messenden Halbleitermaterials gestrahlt wird und dadurch auf der Oberflächen-Dünnschicht des Halbleitermaterials Ladungsträger anregt. Eine auf die Oberfläche des Halbleitermaterials projizierte elektromagnetische Welle wird durch die Oberfläche in einem Maße reflektiert, das in Abhängigkeit von der momentanen Ladungsträgerdichte variiert. Die reflektierte Welle wird detektiert und durch eine Signalverarbeitungsschaltung ausgewertet.

Die Verfahren gemäß dem Stand der Technik haben den Nachteil einer relativ geringen Nachweisempfindlichkeit, erfordern daher für den Gebrauch der Halbleiter-Bauelemente unrealistisch hohe Injektionsraten und benötigen eine lange Zeit, um die detaillierte Topographie eines ganzen Wafers zu ermitteln.

Der Erfindung liegt die Aufgabe zugrunde, ein Verfahren und eine Vorrichtung zu schaffen, mit welcher die detaillierte Topographie eines Wafers mit geringen Injektionsraten in kurzer Zeit ermittelt werden kann.

Diese Aufgabe wird durch die Merkmale des Anspruchs 1 gelöst. Der Kern der Erfindung besteht darin, dass zumindest ein Teilbereich der zu untersuchenden Probe selbst als Teilelement eines Resonanz-Systems fungiert, und eine durch gesteuerte Anregung der Probe verursachte Veränderung der Impedanz des Resonanz-Systems zeitaufgelöst gemessen wird. Dies führt zu einer wesentlich höheren Nachweisempfindlichkeit und einer erheblichen Zeitersparnis gegenüber dem Stand der Technik.

Weitere vorteilhafte Ausgestaltungen der Erfindung ergeben sich aus den Unteransprüchen.

Zusätzliche Merkmale und Einzelheiten der Erfindung ergeben sich aus der Beschreibung eines Ausführungsbeispiels anhand der Zeichnungen. Es zeigen:
- Fig. 1: eine schematische Ansicht einer Vorrichtung gemäß einem Ausführungsbeispiel,
- Fig. 2: eine schematische Ansicht einer Mikrowellenbrücke mit einem daran gekoppelten Resonanz-System und einer Mess-Einrichtung, und
- Fig. 3: eine Detailansicht des Resonanz-Systems.

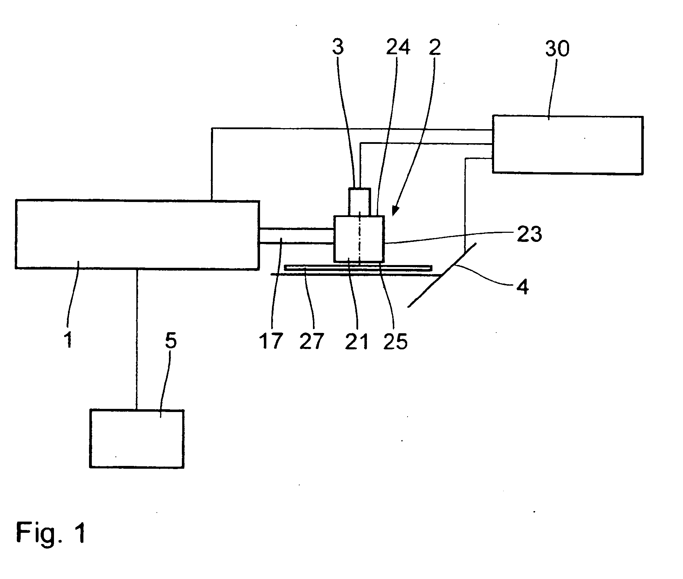

Im Folgenden wird unter Bezugnahme auf Fig. 1 der Aufbau der Vorrichtung beschrieben. Eine Vorrichtung zur Erfassung elektrischer Eigenschaften einer Probe aus einem anregbaren Material umfasst eine Mikrowellenbrücke 1, ein Resonanz-System 2, mindestens eine Anregungs-Quelle 3, eine Positionier-Vorrichtung 4 und eine Mess-Einrichtung 5. Außerdem kann eine in der Fig. 1 nicht dargestellte Temperaturregelung zum Abkühlen oder zum Erwärmen des Resonanz-Systems 2 vorgesehen sein. Des weiteren kann eine in der Fig. 1 ebenfalls nicht dargestellte Vorrichtung zur Evakuierung des Resonanz-Systems 2 vorgesehen sein.

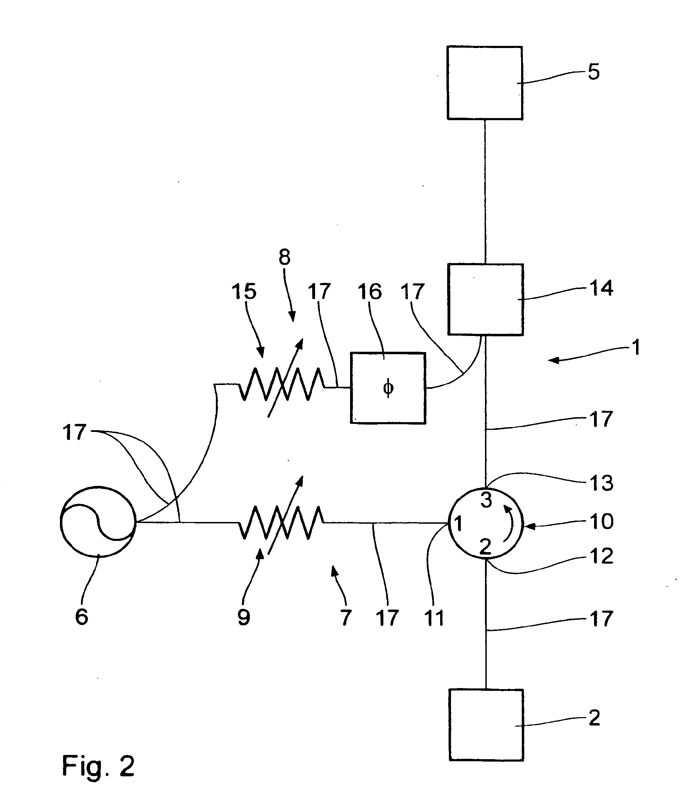

Als erstes wird die an sich bekannte Mikrowellenbrücke 1 unter Bezugnahme auf Fig. 2 näher beschrieben. Die Mikrowellenbrücke 1 umfasst eine Mikrowellenquelle 6, welche beispielsweise eine Gunn-Diode sein kann. Sie erzeugt Mikrowellen im Bereich von 0,1 bis 300 GHz, insbesondere im Bereich von 1 bis 100 GHz, insbesondere im Bereich von 6 bis 11 GHz, d. h. im X-Band. Die Frequenz der von der Mikrowellen-Quelle 6 erzeugten Mikrowellen ist abstimmbar. Die Mikrowellen werden von einem nicht näher dargestellten Splitter auf einen Hauptarm 7 und einen Referenzarm 8 verteilt. Im Hauptarm 7 ist ein erster Dämpfer 9 vorgesehen. Zwischen dem ersten Dämpfer 9 und dem an die Mikrowellenbrücke 1 gekoppelten Resonanz-System 2 ist ein Zirkulator 10 vorgesehen. Dabei ist ein erster Arm 11 des Zirkulators 10 mit dem ersten Dämpfer 9 verbunden. Ein zweiter Arm 12 des Zirkulators 10 ist mit dem Resonanz-System 2 verbunden. Schließlich ist ein dritter Arm 13 des Zirkulators 10 mit einem Mischer 14 verbunden. Der Referenzarm 8 weist einen zweiten Dämpfer 15 und einen Phasenschieber 16 auf. Auch der Referenzarm 8 ist mit dem Mischer 14 verbunden. Die Verbindungen in der Mikrowellenbrücke 1 sind als Wellenleiter 17, d. h. in mikroweHenübertragender Weise ausgebildet. Sie können beispielsweise als Hohlleiter oder Koaxialkabel ausgebildet sein. Die Mikrowellenbrücke 1 kann auch nur einen oder gar keinen Dämpfer aufweisen.

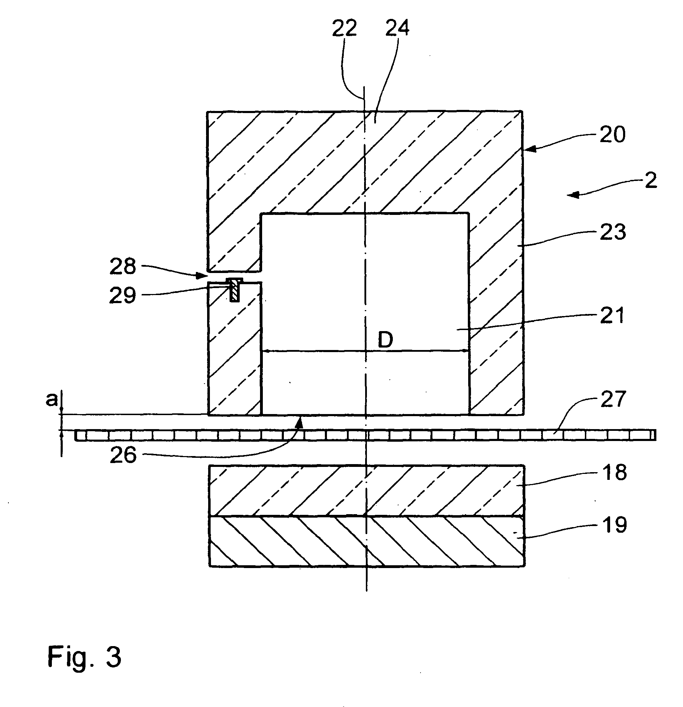

Im Folgenden wird unter Bezugnahme auf Fig. 3 das Resonanz-System 2 beschrieben. Das Resonanz-System 2 umfasst einen Mikrowellen-Resonator, eine zu untersuchende Probe, ein Mikrowellen absorbierendes Dielektrikum 18 und einen Mikrowellen-Reflektor 19. Das Dielektrikum 18 kann beispielsweise aus Glas, Teflon oder Luft sein. Der Mikrowellen-Reflektor 19 besteht aus einem Material mit hoher elektrischer Leitfähigkeit, beispielsweise einem Metall, insbesondere Cu, Au, Al, Messing etc., oder einem hochdotierten Halbleitermaterial. Es ist möglich, für eine Probe mehr als einen Mikrowellen-Resonator vorzusehen. Der Mikrowellen-Resonator ist als Hohlraum-Resonator 20, insbesondere als zylindrischer Hohlraum-Resonator 20 ausgebildet. Andere Geometrien des Hohlraum-Resonators 20 sind ebenfalls möglich. Beispielsweise kann der Hohlraum-Resonator 20 auch quaderförmig ausgebildet sein. Der Hohlraum-Resonator 20 hat eine Güte Q, wobei gilt Q > 100, insbesondere Q > 1.000.

Der zylindrische Hohlraum-Resonator 20 weist einen zylinderförmigen Hohlraum 21 mit einer Mittel-Längs-Achse 22 sowie eine den Hohlraum 21 umfangsseitig umgebende Seitenwand 23 und mindestens eine die Stirnseite des Hohlraums 21 abdeckende erste Stirnwand 24 auf. Auf der der ersten Stirnwand 24 entlang der Mittel-Längs-Achse 22 gegenüberliegenden Seite des Hohlraums 21 ist eine zweite Stirnwand 25 vorgesehen. Die zweite Stirnwand 25 weist eine Öffnung 26 auf. Die Öffnung 26 hat vorteilhafterweise einen kreisförmigen Querschnitt mit einem Durchmesser D und ist konzentrisch zur Mittel-Längs-Achse 22 angeordnet. Es gilt: 1 mm < D < 30 cm, insbesondere 1 cm < D < 10 cm. Die den Hohlraum 21 begrenzenden Wände 23, 24, 25 bestehen aus einem Material mit hoher elektrischer Leitfähigkeit, beispielsweise einem Metall, insbesondere Cu, Al, Au, Messing etc. Entlang der Mittel-Längs-Achse 22 befindet sich außerhalb des Hohlraums 21 in einem Abstand a vor der Öffnung 26 eine zu untersuchende Probe. Dabei gilt: a < 5 cm, insbesondere a < 1 cm, insbesondere a < 1 mm. Mit zunehmendem Abstand a nimmt die Güte Q ab. Die Probe besteht aus einem anregbaren Material, insbesondere aus einem Halbleiter-Material. Bei der Probe kann es sich beispielsweise um einen Wafer 27, insbesondere aus Silizium, handeln. Auf der dem Hohlraum-Resonator 20 gegenüberliegenden Seite des Wafers 27 sind das Mikrowellen absorbierende Dielektrikum 18 und der Mikrowellen-Reflektor 19 angeordnet. Sowohl das Dielektrikum 18 als auch der Mikrowellen-Reflektor 19 haben senkrecht zur Mittel-Längs-Achse 22 Abmessungen, welche mindestens so groß sind wie die Öffnung 26 dergestalt, dass sowohl das Dielektrikum 18 als auch der Mikrowellen-Reflektor 19 bei Projektion in Richtung der Mittel-Längs-Achse 22 die Öffnung 26 vollständig überdecken. Sowohl das Dielektrikum 18 als auch der Mikrowellen-Reflektor 19 sind im Wesentlichen flächig ausgebildet. Das Dielektrikum 18 hat eine Dicke im Bereich von 0 cm bis 5 cm. Der Mikrowellen-Reflektor 19 hat eine Dicke, welche größer ist als die Mikrowellenskintiefe, insbesondere größer als 10 µm. Der Mikrowellen-Reflektor 19 kann auch Bestandteil des Wafers 27 selbst sein, insbesondere wenn hochdotiertes Material oder fertige Solarzellen vermessen werden. Alternativ weist das Resonanz-System 2 kein Dielektrikum 18 auf.

Der Hohlraum-Resonator 20 weist in der Seitenwand 23 eine Iris 28 auf. Außerdem ist eine in die freie Öffnung der Iris 28 einschraubbare Abstimm-Schraube 29 vorgesehen. Der Hohlraum-Resonator 20 ist über die Iris 28 mittels eines der Wellenleiter 17 an die Mikrowellenbrücke 1 gekoppelt. Alternativ kann die Iris 28 auch in der ersten Stirnwand 24 vorgesehen sein. Anstelle der Ankopplung über die Iris 28 können die Mikrowellen von der Mikrowellenbrücke 1 auch mittels eines Antennensystems an den Hohlraum-Resonator 20 angekoppelt sein.

Das Resonanz-System 2 hat insgesamt eine Impedanz Z, welche sowohl von der Impedanz des Hohlraum-Resonators 20 als auch von der des Wafers 27 abhängt. Gemäß dem Ausführungsbeispiel ist vorgesehen, mehrere Anregungs-Quellen 3 in der Umgebung des Wafers 27 anzuordnen. Hierunter sind alle Anordnungen zu verstehen, bei welchen die Anregungs-Quellen 3 im Wafer 27 freie Ladungsträger erzeugen können. Bei den Anregungs-Quellen 3 handelt es sich insbesondere um optische Anregungs-Quellen 3, beispielsweise Laser oder LEDs. Die Wellenlänge des Lichtes von der Anregungs-Quelle 3 liegt im Bereich von 200 nm bis 10000 nm, insbesondere im Bereich von 400 nm bis 1200 nm. Jede der Anregungs-Quellen 3 besitzt gegebenenfalls eine, in den Figuren nicht dargestellte, notwendige Optik zur Fokussierung, Intensitätsregelung und Ausrichtung der Anregung. Die Anzahl der Anregungs-Quellen 3 liegt im Bereich von 1 bis 1.000.

Die Anregungs-Quellen 3 sind vorteilhafterweise derart angeordnet und ausgerichtet, dass die Anordnung aller von ihnen auf dem Wafer 27 anregbaren Gebiete den Wafer 27 sowohl lückenlos überdeckt als auch durch eine Drehung um einen Winkel von 60° oder 90° um die Mittel-Längs-Achse 22 in sich selbst übergeht.

Weiterhin ist vorgesehen, den Wafer 27 mittels der Positionier-Vorrichtung 4 in der Ebene senkrecht zur Mittel-Längs-Achse 22 verschiebbar zu lagern. Alternativ kann der Wafer 27 ortsfest gelagert sein und der Hohlraum-Resonator 20 in der Ebene senkrecht zur Mittel-Längs-Achse 22 verschiebbar angeordnet sein. Hierbei überdecken das Dielektrikum 18 und der Mikrowellen-Reflektor 19 die Öffnung 26 auch nach einer Verschiebung des Hohlraum-Resonators 20 vollständig. Die Positionier-Vorrichtung 4 kann als Roboter, Waferhandler, Transportbänder etc. ausgebildet sein. Prinzipiell können der Mikrowellen-Reflektor und das Dielektrikum mit dem Resonator auch mitbewegt werden.

Die Mikrowellenbrücke 1, die mindestens eine Anregungs-Quelle 3 und die Positionier-Vorrichtung 4 sind mit einer programmierbaren Steuer-Einrichtung 30 verbunden.

Im Folgenden wird die Funktionsweise der erfindungsgemäßen Vorrichtung beschrieben. Zur Erfassung der elektrischen Eigenschaften des zu testenden Wafers 27 werden Mikrowellen von der Mikrowellen-Quelle 6 über den Wellenleiter 17 im Hauptarm 7 der Mikrowellenbrücke 1 und weiter nach Passieren des Zirkulators 10 über die Iris 28 an das Resonanz-System 2 gekoppelt. Im Hohlraum-Resonator 20 werden die Mikrowellen von der Seitenwand 23 sowie der ersten und zweiten Stirnwand 24, 25 weitgehend verlustfrei reflektiert. Im Bereich der Öffnung 26 in der zweiten Stirnwand 25 des Hohlraum-Resonators 20 treffen die Mikrowellen auf den Wafer 27 und, sofern der Wafer 27 die Öffnung 26 nicht vollständig abdeckt, auf das Dielektrikum 18 und den Mikrowellen-Reflektor 19. Die auf den Wafer 27 auftreffenden Mikrowellen werden in Abhängigkeit von der Leitfähigkeit des Wafers 27 von diesem reflektiert. Sofern der Wafer 27 nur eine geringe elektrische Leitfähigkeit hat und/oder die Öffnung 26 nicht vollständig überdeckt, werden die aus dem Hohlraum 21 durch die Öffnung 26 austretenden Mikrowellen vom Mikrowellen-Reflektor 19 reflektiert. Der Hohlraum 21 ist somit unabhängig von der Leitfähigkeit des Wafers 27 vollständig von Wänden mit hoher Leitfähigkeit umgeben, d. h. elektrisch abgeschlossen. Die Anordnung des Wafers 27, Mikrowellen-äbsorbierenden Dielektrikums 18 und Mikrowellen-Reflektors 19 in Bezug auf den Hohlraum-Resonator 20, insbesondere in Bezug auf die Öffnung 26, erweist sich bezüglich der untersuchbaren Materialien als äußerst universell. Sie ermöglicht Untersuchungen von Wafern 27 sowohl mit geringer elektrischer Leitfähigkeit als auch mit hoher elektrischer Leitfähigkeit und funktioniert auch dann, wenn der Wafer 27 nur einen Teil der Öffnung 26 überdeckt.

Sofern die an das Resonanz-System 2 gekoppelten Mikrowellen eine geeignete Frequenz haben, tritt der Resonanzfall ein, bei dem sich im Hohlraum 21 stehende Mikrowellen ausbilden. Die Wellenlänge bzw. Frequenz dieser stehenden Mikrowellen ist unter anderem von der Geometrie des Hohlraums 21 sowie insbesondere von der Leitfähigkeit der den Hohlraum 21 umgebenden Wände bzw. von der Leitfähigkeit des Wafers 27 abhängig.

Die Abstimm-Schraube 29 in der Iris 28, an welcher Mikrowellen von der Mikrowellen-Quelle 6 über den Hauptarm 7 mittels des Wellenleiters 17 an den Hohlraum-Resonator 20 gekoppelt werden, wirkt als variabler Kondensator, mittels welchem die Impedanz des Hohlraum-Resonators 20 und damit die Impedanz des Resonanz-Systems 2 geregelt werden kann. Dadurch ist es möglich, den Widerstand des Resonanz-Systems 2 auf den des Wellenleiters 17, welcher den Hauptarm 7 der Mikrowellenbrücke 1 mit dem Hohlraum-Resonator 20 verbindet, abzustimmen, d. h. das Resonanz-System 2 kritisch an die Mikrowellenbrücke 1 anzukoppeln. Im Falle der kritischen Kopplung des Resonanz-Systems 2 an die Mikrowellenbrücke 1 wird die gesamte Leistung der Mikrowellen im Wellenleiter 17 in das Resonanz-System 2 eingekoppelt und keine Leistung vom Resonanz-System 2 reflektiert.

Um sowohl die Frequenz der von der Mikrowellen-Quelle 6 erzeugten Mikrowellen einerseits als auch die Stellung der Abstimm-Schraube 29 in der Iris 28 andererseits auf die Impedanz des Resonanz-Systems 2 abzustimmen wird wie folgt verfahren:

Zunächst wird die Frequenz der von der Mikrowellen-Quelle 6 erzeugten Mikrowellen derart auf das Resonanz-System 2, insbesondere auf die Geometrie des Hohlraum-Resonators 20, abgestimmt, dass sich im Hohlraum-Resonator 20 eine stehende Mikrowelle ausbildet. Danach wird die Abstimm-Schraube 29 in der Iris 28 so justiert, dass das Resonanz-System 2 weitgehend kritisch, d. h. reflexionsfrei, an den den Zirkulator 10 mit dem Resonanz-System 2 verbindenden Wellenleiter 17 gekoppelt ist. Die weitgehend kritische Kopplung kann alternativ durch eine exakte Positionierung einer Antenne im Inneren des Hohlraum-Resonators 20 erreicht werden. Das Abstimmen der Frequenz der von der Mikrowellen-Quelle 6 erzeugten Mikrowellen und die Justierung der Abstimm-Schraube 29 kann bei Bedarf wiederholt werden.

Im Normalfall ist es fast unmöglich, das Resonanz-System 2 völlig reflexionsfrei an die Mikrowellenbrücke 1 zu koppeln. Um dem Rechnung zu tragen, werden die Amplitude und Phase der Mikrowellen im Referenzarm 8 der Mikrowellenbrücke 1 mittels des zweiten Dämpfers 15 und/oder des Phasenschiebers 16 derart justiert, dass sie sich bei der Überlagerung im Mischer 14 gerade gegen die vom Resonanz-System 2 reflektierten Mikrowellen, welche über den dritten Arm 13 vom Zirkulator 10 zum Mischer 14 geleitet werden, aufheben. In diesem Zustand gelangt kein Signal vom Mischer 14 zur Mess-Einrichtung 5.

Das Einschalten der mindestens einen Anregungs-Quelle 3 führt zu einer elektrischen Anregung in einem örtlich begrenzten Teil des Wafers 27. Die Abmessungen des angeregten Teilbereichs des Wafers 27 in Richtung senkrecht zur Mittel-Längs-Achse 22 sind durch die Ausdehnung des Lichtstrahls in dieser Richtung gegeben. Bei dem angeregten Teilbereich handelt es sich insbesondere um ein Gebiet mit, senkrecht zur Mittel-Längs-Achse 22, im Wesentlichen kreisförmigen Durchmesser im Bereich von 1µm bis 4 cm, insbesondere im Bereich von 10 µm bis 5 mm. In Richtung der Mittel-Längs-Achse 22 ist die Ausdehnung des angeregten Teils des Wafers 27 von der Eindringtiefe des Lichtes von der Anregungs-Quelle 3 in den Wafer 27 abhängig.

Die Anregungs-Quellen 3 werden von der Steuereinrichtung 30 pulsierend aktiviert, wobei die Zeitdauer eines Pulses im Bereich von 0,1 µs bis 1 s liegt, insbesondere im Bereich 10 bis 100 µs. Weiterhin werden die Anregungs-Quellen 3 von der Steuer-Einrichtung 30 sequentiell aktiviert mit einer Frequenz im Bereich von 1 Hz bis 100 MHz, insbesondere 1 Hz bis 1 MHz, insbesondere 1 kHz bis 100 kHz.

Durch die Anregung werden im Wafer 27 freie Ladungsträger erzeugt. Somit ändert sich die Leitfähigkeit in zumindest einem Teilbereich einer den Hohlraum 21 begrenzenden Fläche, wodurch sich die Reflexionseigenschaften im Bezug auf die Mikrowellen in diesem Teilbereich verändern. Dadurch ändert sich auch die Impedanz des Resonanz-Systems 2, welches somit nicht länger kritisch, d. h. reflexionsfrei, an die Mikrowellenbrücke 1 gekoppelt ist. Da die Parameter der Mikrowellenbrücke 1 und des Resonanz-Systems 2 gerade so aufeinander abgestimmt wurden, dass sich das Resonanz-System 2 im nicht-angeregten Zustand des Wafers 27 in Resonanz befindet, und da die Güte des Hohlraum-Resonators 20 sehr hoch ist, sind selbst kleinste, durch die Anregung des Wafers 27 erzeugte, Änderungen der Leitfähigkeit des Wafers 27 und damit verbundene Änderungen der Impedanz des Wafers 27 und damit des gesamten Resonanz-Systems 2, sehr empfindlich nachweisbar. Die vom Resonanz-System 2 reflektierte Leistung führt zu einem Mikrowellensignal, welches über den zweiten Arm 12 in den Zirkulator 10 eintritt und über den dritten Arm 13 vom Zirkulator 10 zum Mischer 14 gelangt. Im Mischer 14 wird das reflektierte Signal mit dem vor dem Einschalten einer der Anregungs-Quellen 3, wie oben beschrieben, justierten Mikrowellen-Signal vom Referenzarm 8 der Mikrowellenbrücke 1 überlagert. Vom Mischer 14 gelangt das Signal zur Mess-Einrichtung 5, wo es zeitaufgelöst gespeichert, weiterverarbeitet und ausgewertet wird. Selbst kleinste Änderungen der Resonanzeigenschaften des Resonanz-Systems 2 sind durch diese Anordnung nachweisbar. Dies ermöglicht es, die Anregungsleistung der Anregungs-Quelle 3 bis auf 0.001 mW/cm² zu reduzieren. Eine derartig niedrige Anregungsleistung ist vorteilhaft, da sie im Bereich der tatsächlich auftretenden Anregungsleistung beim späteren Gebrauch des Wafers liegt. Größere Anregungsleistungen bis zu beispielsweise 100 W/cm² sind ebenso möglich.

Die Anregungs-Quellen 3 werden von der Steuer-Einrichtung 30 sequentiell aktiviert. Hierbei liegt das Zeitintervall, welches zwischen dem Ausschalten der vorangehenden Anregungs-Quelle 3 und dem Einschalten der nachfolgenden Anregungs-Quelle 3 liegt, im Bereich von einer 1µs bis 1 s. Insbesondere ist dieses Intervall so gewählt, dass mehr als 90 %, insbesondere mehr als 99 % der durch das Einschalten der vorangehenden Anregungs-Quelle 3 erzeugten Ladungsträger bis zum Einschalten der nachfolgenden Anregungs-Quelle 3 rekombiniert haben.

Um die elektrischen Eigenschaften im gesamten Bereich des Wafers 27 erfassen zu können, kann der Wafer 27 mit Hilfe der Positionier-Vorrichtung 4 gegenüber der Öffnung 26 des Hohlraum-Resonators 20 in Richtung senkrecht zur Mittel-Längs-Achse 22 präzise verschoben werden.

Die durch das Einschalten der Anregungs-Quelle 3 erzeugten freien Ladungsträger haben nur eine begrenzte Lebensdauer nach welcher sie wieder rekombinieren. Hierbei wurde festgestellt, dass die Rekombination der freien Ladungsträger durch Kristalldefekte, wie z. B. Störstellen, Fremdatome oder Traps, beeinflusst wird. Allgemein lässt sich die Transiente nach Ausschalten der Anregungs-Quelle 3 sehr gut durch eine Summe mehrerer Exponentialfunktionen beschreiben. Dabei ist der schnelle Abfall der Transiente ein Maß für die Rekombinationslebensdauer. Im zweiten, langsameren Teil der abfallenden Transiente kann man den Einfluss von Kristalldefekten auf die Ladungsträger beobachten. Eine Auswertung der von der Mess-Einrichtung 5 gemessenen Signale, beispielsweise mit Hilfe der Zwei-Tor-Technik, bei welcher die Signalamplitude in zwei Intervallen, vorzugsweise der gleichen Länge jedoch mit unterschiedlichen Startzeitpunkten nach Ausschalten der Anregungs-Quelle 3, gemessen und weiter ausgewertet wird, ermöglicht somit auf einfache Weise Rückschlüsse über die Verteilung und Konzentration von Kristalldefekten im Wafer 27, sowie über die Diffusionslänge, d. h. die Beweglichkeit der freien Ladungsträger.

Die Anzahl der für eine Ganzwafer-Topografie zu messenden Messpunkte ist abhängig von der gewünschten Auflösung, d. h. dem Durchmesser des Lichtstrahls der Anregungs-Quellen 3, der Größe des Wafers 27 und der Materialqualität. Ein wichtiger Faktor war hierbei bislang außerdem die zur Verfügung stehende Zeit. Mit der erfindungsgemäßen Vorrichtung bzw. dem erfindungsgemäßen Verfahren wird die zur topografischen Erfassung der elektrischen Eigenschaften eines gesamten Wafers benötigte Zeit deutlich reduziert. Für einen typischen Wafer dauert eine derartige topografische Erfassung mit den hier geschilderten Mitteln weniger als 10 s, insbesondere weniger als 1 s.

Zur Verbesserung des Signal-Rausch-Verhältnisses können die Messungen mehrmals wiederholt werden.

## Patentansprüche

1. Vorrichtung zur Erfassung elektrischer Eigenschaften einer Probe aus einem anregbaren Material, insbesondere eines Silizium-Wafers, umfassend:
a. eine Mikrowellen-Quelle (6) zur Erzeugung eines Mikrowellen-Feldes,
b. ein an die Mikrowellen-Quelle (6) in Mikrowellen übertragender Weise gekoppeltes Resonanz-System (2), welches aufweist
i. einen Mikrowellen-Resonator,
ii. eine zu untersuchende Probe,
c. mindestens eine in der Umgebung der Probe angeordnete Anregungs-Quelle (3) zur gesteuerten elektrischen Anregung der Probe und
d. eine Mess-Einrichtung (5) zur Messung mindestens eines physikalischen Parameters des Resonanz-Systems (2).

2. Vorrichtung gemäß einem der vorhergehenden Ansprüche, **dadurch gekennzeichnet, dass** es sich bei dem Mikrowellen-Resonator um einen Hohlraum-Resonator (20) mit einem Hohlraum (21) handelt.

3. Vorrichtung gemäß Anspruch 2, **dadurch gekennzeichnet, dass** der Hohlraum-Resonator (20) eine Öffnung (26) aufweist, vor der die Probe angeordnet ist.

4. Vorrichtung gemäß einem der vorhergehenden Ansprüche, **dadurch gekennzeichnet, dass** auf der der Öffnung (26) abgewandten Seite der Probe ein Mikrowellen-absorbierendes Dielektrikum (18) angeordnet ist.

5. Vorrichtung gemäß einem der vorhergehenden Ansprüche, **dadurch gekennzeichnet, dass** auf der der Öffnung (26) abgewandten Seite der Probe ein Mikrowellen-Reflektor (19) angeordnet ist.

6. Vorrichtung gemäß einem der vorhergehenden Ansprüche, **dadurch gekennzeichnet, dass** die mindestens eine Anregungs-Quelle (3) gepulst gesteuert ist.

7. Vorrichtung gemäß einem der vorhergehenden Ansprüche, **dadurch gekennzeichnet, dass** mehrere Anregungs-Quellen (3) vorgesehen sind.

8. Vorrichtung gemäß Anspruch 7, **dadurch gekennzeichnet, dass** die Anregungs-Quellen (3) sequentiell gesteuert sind.

9. Vorrichtung gemäß einem der vorhergehenden Ansprüche, **dadurch gekennzeichnet, dass** die Probe und der Hohlraum-Resonator (20) in einer Ebene senkrecht zur Mittel-Längs-Achse (22) relativ zueinander verschiebbar sind.

10. Verfahren zur topographischen Erfassung elektrischer Eigenschaften einer Probe aus einem anregbaren Material, insbesondere eines Silizium-Wafers (27), umfassend die folgenden Schritte:
a. Bereitstellen
i. einer abstimmbaren Mikrowellen-Quelle (6),
ii. eines an die Mikrowellen-Quelle (6) abstimmbar gekoppelten Resonanz-Systems (2), umfassend einen Mikrowellen-Resonator und eine Probe,
iii. mindestens einer in der Umgebung der Probe angeordneten Anregungs-Quelle (3) sowie
iv. einer Mess-Einrichtung (5),
b. Erzeugen eines Mikrowellen-Feldes im Resonanz-System (2) mittels der Mikrowellen-Quelle (6),
c. Abstimmen der Frequenz des Mikrowellen-Feldes auf eine Resonanz-Frequenz des Resonanz-Systems (2) in einem nicht-angeregten Zustand der Probe,
d. Abstimmen der Kopplung des Resonanz-Systems (2) an die Mikrowellen-Quelle (6) derart, dass die Ankopplung weitgehend reflexionsfrei ist,
e. lokale Anregung der Probe, insbesondere Erzeugen von freien Ladungsträgern in der Probe, durch gesteuertes Einschalten der mindestens einen Anregungs-Quelle (3), und
f. zeitlich aufgelöste Erfassung der durch die Anregung bewirkten Änderung mindestens eines physikalischen Parameters des Resonanz-Systems (2) mittels der Mess-Einrichtung (5).

## Claims

1. Device for detecting electrical properties of a sample of an excitable material, in particular of a silicon wafer, comprising:
a. a microwave source (6) for generating a microwave field;
b. a resonance system (2) which is coupled to the microwave source (6) in a microwave-transmitting manner, the resonance system (2) comprising
i. a microwave resonator;
ii. a sample to be examined;
c. at least one excitation source (3) arranged in the surroundings of the sample for controlled electrical excitation of the sample; and
d. a measuring device (5) for measuring at least one physical parameter of the resonance system (2).

2. Device according to one of the preceding claims, **characterized in that** the microwave resonator is a cavity resonator (20) with a cavity (21).

3. Device according to claim 2, **characterized in that** the cavity resonator (20) comprises an opening (26) in front of which the sample is arranged.

4. Device according to one of the preceding claims, **characterized in that** a microwave-absorbing dielectric (18) is arranged on the side of the sample remote from the opening (26).

5. Device according to one of the preceding claims, **characterized in that** a microwave reflector (19) is arranged on the side of the sample remote from the opening (26).

6. Device according to one of the preceding claims, **characterized in that** the at least one excitation source (3) is activated pulsedly.

7. Device according to one of the preceding claims, **characterized in that** several excitation sources (3) are provided.

8. Device according to claim 7, **characterized in that** the excitation sources (3) are activated sequentially.

9. Device according to one of the preceding claims, **characterized in that** the sample and the cavity resonator (20) are displaceable relative to each other in a plane perpendicular to the central longitudinal axis (22).

10. Method for topographic detection of electrical properties of a sample of an excitable material, in particular of a silicon wafer (27), the method comprising the following steps:
a. providing
i. a tunable microwave source (6);
ii. a resonance system (2) which is coupled to the microwave source (6) in a tunable manner, the resonance system (2) comprising a microwave resonator and a sample;
iii. at least one excitation source (3) which is arranged in the surroundings of the sample; and
iv. a measuring device (5);
b. generating a microwave field in the resonance system (2) by means of the microwave source (6);
c. tuning the frequency of the microwave field to a resonance frequency of the resonance system (2) in a non-excited state of the sample;
d. tuning the coupling of the resonance system (2) to the microwave source (6) in such a way that the coupling is substantially free of reflections;
e. local excitation of the sample, in particular generating free charge carriers in the sample by controlled activation of the at least one excitation source (3); and
f. time-resolved detection of the excitation-induced change of at least one physical parameter of the resonance system (2) by means of the measuring device (5).

## Revendications

1. Dispositif de détermination de propriétés électriques d'un échantillon en matériau excitable, en particulier d'une plaquette de silicium, comprenant :
a. une source micro-ondes (6) pour générer un champ micro-ondes,
b. un système de résonance (2) couplé à la source micro-ondes d'une manière transmettant des micro-ondes, lequel présente
i. un résonateur micro-ondes,
ii. un échantillon à examiner,
c. au moins une source d'excitation (3) disposée au voisinage de l'échantillon pour l'excitation électrique commandée de l'échantillon, et
d. un dispositif de mesure (5) pour mesurer au moins un paramètre physique du système de résonance (2).

2. Dispositif selon l'une des revendications précédentes, **caractérisé en ce que** le résonateur micro-ondes est un résonateur (20) à cavité (21).

3. Dispositif selon la revendication 2, **caractérisé en ce que** le résonateur à cavité (20) présente une ouverture (26) devant laquelle est disposé l'échantillon.

4. Dispositif selon l'une des revendications précédentes, **caractérisé en ce que**, sur le côté de l'échantillon opposé à l'ouverture (26), est disposé un diélectrique (18) absorbant les micro-ondes.

5. Dispositif selon l'une des revendications précédentes, **caractérisé en ce que**, sur le côté de l'échantillon opposé à l'ouverture (26), est disposé un réflecteur hyperfréquence (19).

6. Dispositif selon l'une des revendications précédentes, **caractérisé en ce que** la au moins une source d'excitation (3) est commandée de manière pulsée.

7. Dispositif selon l'une des revendications précédentes, **caractérisé en ce que** sont prévues plusieurs sources d'excitation (3).

8. Dispositif selon la revendication 7, **caractérisé en ce que** les sources d'excitation (3) sont commandées de manière séquentielle.

9. Dispositif selon l'une des revendications précédentes, **caractérisé en ce que** l'échantillon et le résonateur à cavité (20) sont translatables l'un par rapport à l'autre dans un plan perpendiculaire à l'axe longitudinal médian (22).

10. Procédé de détermination topographique de propriétés électriques d'un échantillon en matériau excitable, en particulier d'une plaquette de silicium (27), comprenant les étapes suivantes :
a. Mettre à disposition
i. une source micro-ondes (6) accordable,
ii. un système de résonance (2) couplé de manière accordable à la source micro-ondes, comprenant un résonateur micro-ondes et un échantillon,
iii. au moins une source d'excitation (3) disposée au voisinage de l'échantillon, ainsi que
iv. un dispositif de mesure (5),
b. Générer un champ micro-ondes dans le système de résonance (2) au moyen de la source micro-ondes (6),
c. Accorder la fréquence du champ micro-ondes sur une fréquence de résonance du système de résonance (2) dans un état non-excité de l'échantillon,
d. Accorder le couplage du système de résonance (2) à la source micro-ondes (6) de façon que le couplage soit, dans une large mesure, sans réflexion.
e. Excitation locale de l'échantillon, en particulier, production de porteurs de charge libres dans l'échantillon, par mise en circuit commandée de la au moins une source d'excitation (3), et
f. Détermination à résolution temporelle de la modification, opérée par l'excitation, d'au moins un paramètre physique du système de résonance (2) au moyen du dispositif de mesure (5).
